(19) Europäisches Patentamt
European Patent Office
Office européen des brevets

(11) **EP 4 012 734 A1**

(12) **EUROPEAN PATENT APPLICATION**

(43) Date of publication:
**15.06.2022 Bulletin 2022/24**

(21) Application number: **20213448.2**

(22) Date of filing: **11.12.2020**

(51) International Patent Classification (IPC):
*H01F 38/26* (2006.01)   *H01F 3/14* (2006.01)
*H01F 27/42* (2006.01)   *G01R 15/06* (2006.01)

(52) Cooperative Patent Classification (CPC):
**H01F 38/26; G01R 15/06; H01F 3/14; H01F 27/425**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Energy Global GmbH & Co. KG
81739 München (DE)**

(72) Inventor: **The designation of the inventor has not
yet been filed**

(54) **ELIMINATING PHASE ERROR IN CAPACITIVE VOLTAGE TRANSFORMER**

(57) Embodiments of the present invention relate to eliminating phase error in a capacitor voltage transformer (300). The capacitor voltage transformer (300) comprises an intermediate transformer (218). The intermediate transformer (218) comprises a core (218B) having at least one limb (232, 234). The at least one limb (232, 234) is configured with one or more gaps (232A, 232B, 234A, 234B, 234C) for producing a compensating inductance in a primary section (218A(1)) of the intermediate transformer (218) for eliminating phase error in the CVT (300) without using any separate and dedicated inductance section in the primary section (218A(1)) of the intermediate transformer (218). Further, the intermediate transformer (218) plays dual-role by eliminating the phase error in the primary section (218A(1)) of the intermediate transformer (218) and achieving transformation ratio in a secondary section (218A(2)) of the intermediate transformer (218).

FIG. 3A

**Description**

The present disclosure generally relates to capacitive voltage transformers (CVTs), and more particularly to eliminating phase error in a capacitive voltage transformer.

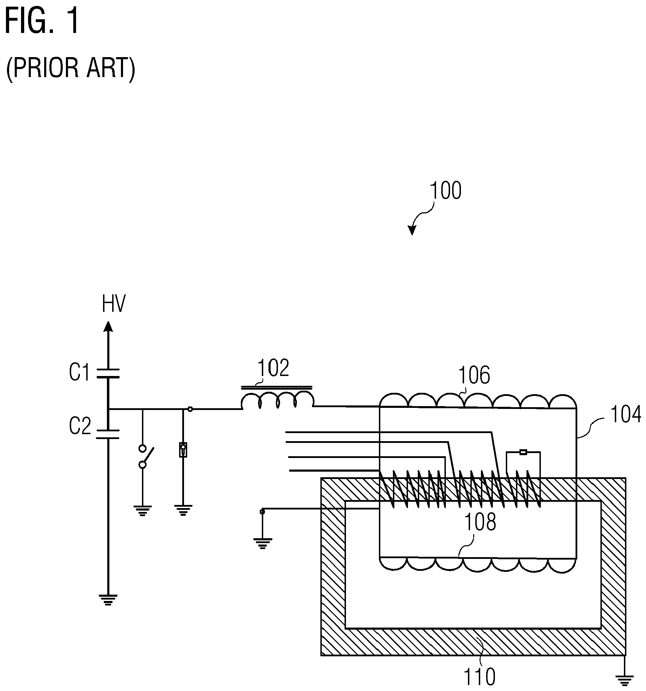

The use of CVTs as instruments or devices for measuring and shielded relaying purposes on high voltage power transmission systems have been known in the art. The CVTs have played a crucial role in reshaping standards defined in specific technical vertical of electrical engineering. Basically, the CVT is connected across high voltage lines and usually provided with a tapping point at some intermediate voltage i.e. a fraction of a total voltage. An existing CVT 100 is shown in FIG 1 comprising capacitors C1 and C2 connected in series and an intermediate transformer 104 is connected to the secondary capacitor C2 at the tapping point. The intermediate transformer 104 has a primary section 106, a secondary section 108 and a core 110. The output of the intermediate transformer 104 at the secondary section 108, i.e. low voltage due to step down by the secondary windings, is supplied to meters, relays or other devices e.g. for controlling& measuring purposes, as desired.

Further, the CVT 100 has an electromagnetic unit (EMU) tank having an inductance section 102. The inductance section 102 comprises a set of inductors provided on the primary section 106 of the intermediate transformer 104. The inductance section 102 having inductors produces inductance in the primary section 106 of the intermediate transformer 104 resulting in elimination of phase error in the CVT 100. Thus, the existing CVT 100 requires a dedicated and a separate inductance section 102 for eliminating the phase error. The usage of dedicated and separate inductance section 102 in the CVT 100 is costly and also occupies space in the EMU tank of the CVT 100. In addition, the existing CVT 100 uses insulating oil in large amount to provide electrical insulating properties which causes adverse impact on the environment at the time of discharge/leakage of the insulating oil or at the end of life cycle of the CVT.

In light of the above, there is a need of a viable solution to produce inductance in the CVT thereby reducing the overall cost of the CVT while reasonably reducing phase errors in the CVT without using any dedicated and a separate inductance section in the CVT 100. Further, there is also a need for a solution that reduces the requirement of the large amount of the insulating oil in the CVT.

The object of the present disclosure is achieved by a capacitive voltage transformer (CVT). The capacitive voltage transformer (CVT) comprises an intermediate transformer. The intermediate transformer comprises a core having at least one limb. The at least one limb is configured with one or more gaps for producing a compensating inductance in a primary section of the intermediate transformer for eliminating phase error in the CVT.
In an embodiment, the one or more gaps on the at least one limb are longitudinal starting from a first end to a second end of the at least one limb.

In an embodiment, each of the one or more gaps on the at least one limb range between 10 microns to 5 millimeter (mm) in length.

In an embodiment, the one or more gaps on the at least one limb are equal in length.

In an embodiment, the one or more gaps on the at least one limb are different in length.

In an embodiment, the one or more gaps produce the inductance in a range of 50-170 Henry (H) in the primary section of the intermediate transformer based equivalent capacitance requirement.

In an embodiment, the intermediate transformer comprises a secondary section having a tuning choke coil.

In an embodiment, the tuning choke coil is magnetically coupled to the core of the intermediate transformer for tuning transformation ratio error.

In an embodiment, an inductance coil in a range of 3-8 milli-Henry (mH) is introduced in secondary windings of the secondary section of the intermediate transformer to achieve a stable behavior of the CVT.

In an embodiment, the one or more gaps are filled using at least one of a mylar film, a polypropylene film and a press board.

The object of the present disclosure is also achieved by an intermediate transformer. The intermediate transformer comprises a core having at least one limb. The at least one limb is configured with one or more gaps for producing compensating inductance in a primary section of the intermediate transformer for eliminating phase error in a circuit.

Still other aspects, features, and advantages of the invention are readily apparent from the following detailed description, simply by illustrating a number of particular embodiments and implementations, including the best mode contemplated for carrying out the invention. The invention is also capable of other and different embodiments, and its several details can be modified in various obvious respects, all without departing from the scope of the invention. Accordingly, the drawings and description are to be regarded as illustrative in nature, and not as restrictive.

A more complete appreciation of the present disclosure and many of the attendant aspects thereof will be readily obtained as the same becomes better understood by reference to the following description when considered in connection with the accompanying drawings:

FIG 1        is a circuit diagram of an existing capacitor voltage transformer disclosed in prior arts;

FIG 2          is a schematic representation of a capacitor voltage transformer, in accordance with an embodiment of the present invention;

FIG 3A          is a circuit diagram of a capacitor voltage transformer as shown in FIG 1, in accordance with an embodiment of the present invention;

FIG 3B          is a circuit diagram depicting magnetic coupling between a tuning choke coil and a core, in accordance with an embodiment of the present invention;

FIGS 4A-4D          are schematic representation of a core having at least one limb with one or more gaps, in accordance with an embodiment of the present invention;

FIG 5          is a graph of voltage transformation ratio achieved for intermediate transformer of CVT, in accordance with an embodiment of the present invention; and

FIG 6          is a graph of an applied voltage and measured current to achieve compensating inductance in a primary section of an intermediate transformer of CVT, in accordance with an embodiment of the present invention.

Various embodiments are described with reference to the drawings, wherein like reference numerals are used to refer the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

Examples of a capacitor voltage transformer (CVT) for one of measuring, shielding, relaying and controlling high voltage power transmission are disclosed herein. In the following description, for the purposes of explanation, numerous specific details are set forth in order to provide a thorough understanding of the embodiments of the invention. It is apparent, however, to one skilled in the art that the embodiments of the invention may be practiced without these specific details or with an equivalent arrangement. In other instances, well-known structures and devices are shown in block diagram form in order to avoid unnecessarily obscuring the embodiments of the invention.

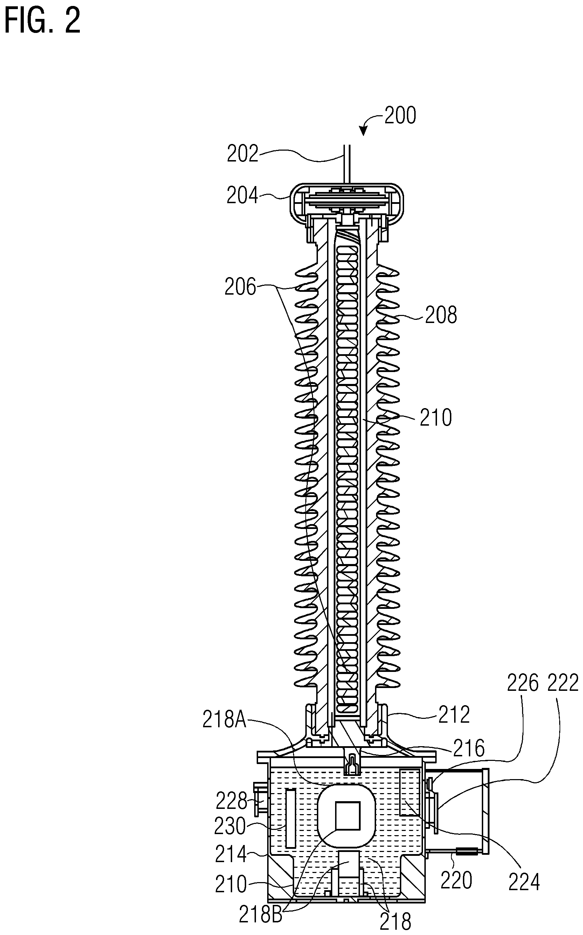

FIG 2 is a schematic representations of a capacitor voltage transformer (CVT) 200, in accordance with an embodiment of the present invention. In the present examples, the capacitor voltage transformer 200 may be implemented for measuring, shielding, relaying and controlling high voltage power transmission. In an embodiment, the capacitor voltage transformer 200 is single-phase transformer configured to use in high power voltage systems handling voltage more than 72.5 kilo volts (KV). Herein, the capacitor voltage transformer 200 basically steps-down high voltage (HV) signal to a low voltage (LV) signal suitable to be used in metering units, protection relay devices, automatic control devices and the like.

The capacitor voltage transformer 200, as disclosed in the present invention, comprises a high voltage (HV) input terminal 202, a capacitor oil compensation arrangement 204, a capacitor stack assembly 206 having a first capacitor C1 and a second capacitor C2, a composite/porcelain insulator 208, insulating oil 210, a bottom plate 212 for the capacitor stack assembly 206, an electromagnetic unit (EMU) tank 214, low voltage (LV) bushing 216, an LV box assembly 220, and secondary terminal arrangement 222 in the LV box assembly 220.

The high voltage (HV) input terminal 202 is connected to HV grid lines and receives HV input power from the HV power grid lines. In an embodiment, the HV input terminal 202 is an aluminum rod connected to the HV grid lines. The capacitor oil compensation arrangement 204 is used for volumetric oil compensation with respect to temperature. The capacitor oil compensation arrangement 204 circulates oil in the CVT 200 for reducing pressure in the CVT 200 due to change in internal and external temperature. By way of an example, at the time of increase in temperature (like in summers or due to internal faults), oil in the CVT 200 expands and in winters, when the temperature decreases, contraction of oil happens. Such expansion and contraction of the oil is handled by the capacitor oil compensation arrangement 204.

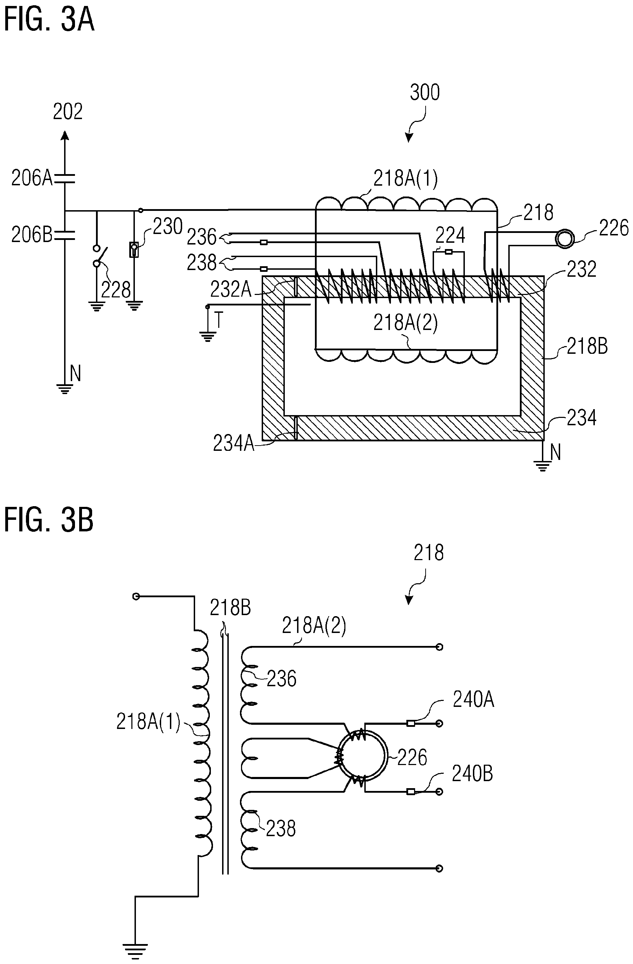

The capacitor stack assembly 206 comprises a first capacitor C1 and a second capacitor C2 as explained in FIG 3A below. The composite/porcelain insulator 208 is used as an external insulator that prevents the internal insulation of the CVT 200 from foreign particles such as rain, dust and the like. In an embodiment, the composite insulator 208 is a fiber reinforced plastic (FRP) tube formed under silicon rubber shed. The insulating oil 210 is used for insulation purpose to sustain the dielectric requirement such as stress in the CVT 200. In an embodiment, the insulating oil 210 is a capacitive oil having electrical insulating properties. Such an insulating oil enhances the withstand capability of the capacitor stack assembly 206 having capacitors C1, C2 in the CVT 200 . In the EMU tank 216, the insulating oil 210 impregnates the insulating paper used in an intermediate transformer 218 to enhance the electrical insulation properties of the intermediate transformer 218.

The bottom plate 212 for the capacitor stack assembly 206 comprises two flanges namely a top flange and a bottom flange. The bottom flange is sealed to the EMU tank 214 and has an insulator for sealing the EMU tank 214 with the bottom plate 212 for providing safe environment to the CVT 200. The low voltage (LV) bushing 216 of the CVT 200 hermetically seals the capacitor stack assembly 206 and act as a barrier between the EMU tank 216 and the insulating oil 210. The LV bushing 216 also brings wires outside the capacitor stack assembly 206. In an embodiment, the LV bushing 216 is an epoxycasted component.

The LV box assembly 220 encloses the secondary terminal arrangement 222 and a tuning choke coil 226 of a secondary section of an intermediate transformer in the EMU tank 216. The LV box assembly 220 provides a closed environment for preventing entrance of moisture inside the CVT 200. The secondary terminal arrangement 222 in the LV box assembly 220 is a terminal box protecting fuses, wires and the like from over-current or faulty situation.

The electromagnetic unit (EMU) tank 214 of the CVT 200 comprises an intermediate transformer 218 having a primary section 218A(1) and a secondary section 218A(2), and a core 218B immersed in the insulating oil 210. Herein, the intermediate transformer 218 is connected between an intermediate voltage terminal and an earth terminal. The primary section 218A(1) of the intermediate transformer 218 comprises a medium voltage (MV) tap switch 228 and a protective device 230 (such as medium voltage (MV) arrestor). The secondary section 218A(2) of the intermediate transformer 218 further comprises a harmonic suppression filter 224 and the tuning choke coil 226. The working of intermediate transformer 218 and its components is explained in greater details in FIG 3A.

FIG 3A is a circuit diagram 300 of a capacitor voltage transformer 200, in accordance with an embodiment of the present invention. As depicted, the circuit 300 shows high voltage (HV) input terminal 202 connected with a first capacitor 206A and a second capacitor 206B of the circuit 300. The first capacitor 206A and the second capacitor 206B are connected in series. Further, the values of the first capacitor 206A and the second capacitor 206B would depend on manufacturer's requirement and on the requirement of the EMU tank 214. The values of the first capacitor 206A and the second capacitor 206B may be chosen such as equivalent capacitance value can be achieved. Herein, the equivalent capacitance value may be determined using formula of $C_{equivalent} = (C1*C2) / (C1+C2)$. The circuit 300 also shows an intermediate transformer 218 comprising a primary section 218A(1) and a secondary section 218A(2). Herein, the intermediate transformer 218 is a step-down voltage transformer used for reducing voltage of a high voltage signal provided as an input to the intermediate transformer 218.

The primary section 218A(1) of the intermediate transformer 218 comprises the medium voltage (MV) tap switch 228 and the protective device 230 (such as medium voltage (MV) arrestor). The secondary section 218A(2) of the intermediate transformer 218 comprises a harmonic suppression filter 224, a tuning choke coil 226, a first set of fuses 236, a second set of fuses 238. The circuit 300 also shows a core 218B arranged in between the primary section 218A(1) of the intermediate transformer 218 and the secondary section 218A(2) of the intermediate transformer 218. In an embodiment, the core 218B may be of square or rectangle shape and may be made up of iron or any other material suitable for electrical conductivity.

As depicted in FIG 3A, the primary section 218A(1) also includes a plurality of winding on at least one limp 232, 234 of the core 218B, wherein one terminal of the winding is coupled between the first capacitor 206A and the second capacitor 206B, while the other terminal of the winding is grounded. Furthermore, the secondary section 218A(2) of the intermediate transformer 218 includes a plurality of windings on the at least one limp 232, 234 of the core 218, wherein the plurality of windings include a first winding magnetically coupled to the tuning choke coil 226, a second winding connected to the filter 224, and a third winding coupled to the tuning choke coil 226 and terminates in the first set of fuses 236 . Further, a fourth winding is coupled to the tuning choke coil 226 and terminates in the second set of fuses 238. It may be noted that this kind of configuration of the primary section 218A(1) and the secondary section 218A(2) of the intermediate transformer 218 is also applicable to a shelltype transformer.

Further, the medium voltage (MV) tap switch 228 is a manual switch for disconnecting and connecting the intermediate transformer 218 from MV tap voltage. If the MV tap switch 218 is closed, then the maintenance work can be done in the LV box assembly 220 of the CVT 300. The protective device 230 is connected parallel to the second capacitor 206B to protect the intermediate transformer 218 from abnormalities such as over-voltage oscillations in the circuit 300. On the other side, the protective device 230 is grounded. The primary section 218A(1) of the intermediate transformer 218 with multiple taps can be used for phase error tuning purpose.

In the circuit 300, voltage reduces from the HV input terminal 202 to the secondary section 218A(2) of the intermediate transformer 218 in two stages. In first stage, the capacitor stack assembly 206 having the first capacitor 206A and the second capacitor 206B reduces the voltage. By way of an example, 66kV/√3 to 1200/√3 Kilo Volts (KV) is reduced to MV tap of 5-21 KV by the capacitor stack assembly 206. In the second stage, the intermediate transformer 218 further reduces the voltage. By way of an example, the voltage is reduced from 5-21 KV to 63.5-110 volts at the secondary section 218A(2) of the intermediate transformer 218. Further, HV primary voltage is connected across capacitor divider 206A and 206B the protective device 230 appears across the second capacitor 206B.

The filter 224 is connected on the secondary section 218A(2) of the intermediate transformer 218 to suppress ferro resonance oscillation and suppress the excessive abnormal energy in the secondary section 218A(2) of the intermediate transformer 218. Herein, the filter 224 handles destruction of the intermediate transformer 218 and prevents internal insulation from over-voltages in the CVT 300.

The first set of fuses 236 and the second set of fuses 238 on the secondary section 218A(2) of the intermediate transformer 218 prevents short circuit and over-current in the circuit 300. The over current in the circuit 300 happens when a huge amount of current is drawn which rises the temperature in the circuit 300 and may eventually result in burning of the intermediate transformer 218.

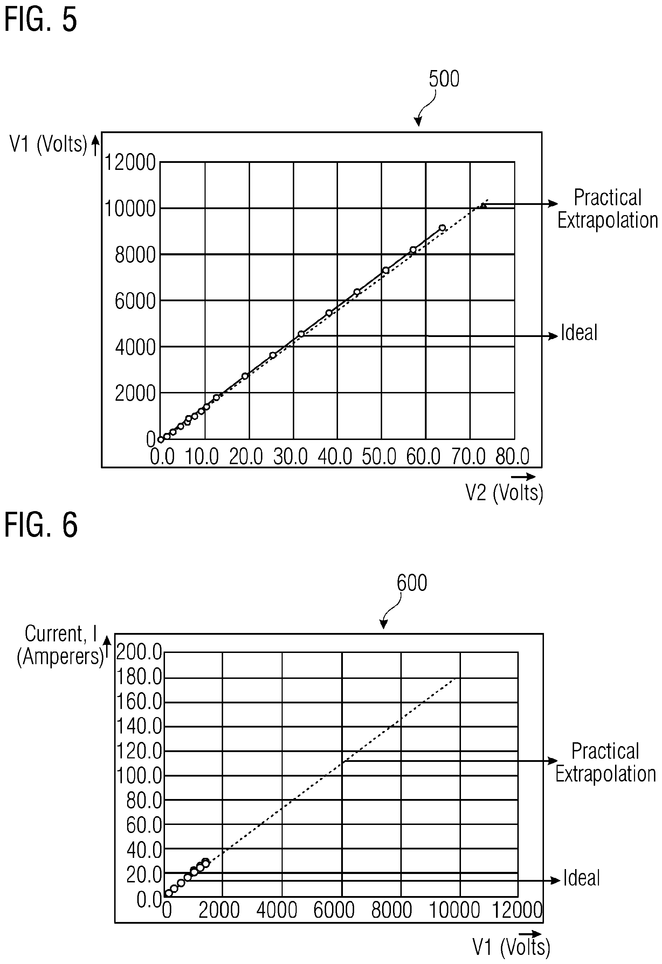

The tuning choke coil 226 is magnetically coupled to the core 218B of the intermediate transformer 218 in order to bring the effect of secondary voltage transformation and to tune transformation ratio error as discussed in FIG 5. By changing one or two turns of the windings, the transformation ratio error is shifted accordingly and can achieve desired accuracy class fine by tuning. Further, the secondary windings lead may be wound on this tuning choke coil 226.

The core 218B includes at least one limb 232, 234. Herein, the core 218B comprises a first limp 232 and a second limp 234. One or more gaps 232A, 234A may be provided on either the first limp 232, the second limp 234 or both for producing compensating inductance in a primary section 218A(1) of the intermediate transformer 218 for eliminating phase error in the CVT 300. Herein, the one or more gaps 232A, 234A means two magnetic circuit separated from each other. In an embodiment, a gap 232A may be provided on the first limp 232 and a gap 234A may be provided on the second limp 234. The gaps 232A, 234A may be placed on the at least one limb 232, 234 of the core 218B based on the circuit based on convenience, ease of manufacturing and handling aspects. The gaps 232A, 234A is determined to produce compensating inductance such that phase error is either eliminated or minimized to required value (as defined by customer accuracy class). Herein, the compensating inductance is the inductance produced by introducing the gaps 232A, 234A in the core 218B without using any separate and dedicated inductance section in the primary section 218A(1) of intermediate transformer 218.

Further, the one or more gaps 232A, 234A are marinated or filled or created using at least one of a mylar film, a polypropylene film and a press board. Such gaps 232A, 234A are filled in the core 218B to maintain the gaps 232A, 234A in the core 218B and such gaps 232A, 234A do not get altered. Depending on the gaps 232A, 234A requirement in the core 218B, either fine & coarse gap setting can be done based on the thickness of around 10 micron to 0.2 mm using the mylar/polypropylene film and of gap setting of 0.2 to 5 mm using the pressboard. It is to be noted that incrementing or decrementing number of turns on the secondary windings may adjust secondary side voltage (V2) depending upon the gaps 232A, 234A on the at least one limb 232, 234.

The one or more gaps 232A, 234A in the core 218B may be determined based on requirement of the compensating inductance in the circuit 300. The compensating inductance (L) may be calculated using the following mathematical derivation:

$$L=1/(C1+C2)*(2 \pi F_r)^2$$

where, C1 is value of the first capacitor 206A in the CVT circuit 300, C2 is value of the second capacitor 206B in the CVT circuit 300, and $f_R$ is rated frequency.

Further, each of the one or more gaps 232A, 234B($l_g$) in the core 218B of the intermediate transformer 218 is calculated using the following mathematical derivation:

$$L=\mu_o N^2 A_g/l_g$$

where, Ag is an area of the gap, $l_g$ is length of the gap and $\mu_o$ is permeability of air.

Furthermore, the inductance in the primary section 218A(1) of the intermediate transformer 218 is produced by making reactance from the primary section 218A(1) of the intermediate transformer 218, $Xl=L*(2\pi F_r)$ in the circuit 300 equal to capacitive reactance $X_c= 1/[2\pi F_r(C1+C2)]$ at rated frequency, $F_r$. Thus, by introducing the compensating inductance, the reactance in circuit 300 $Xl=L*(2*3.147*F_r)$ is brought equal to capacitive reactance $X_c= 1/[2*3.147*F_r*(C1+C2)]$ at rated frequency $F_r$.

In an embodiment, the gaps 232A, 234A is concluded with the following calculation for an example of 245 KV CVT (highest system voltage, HSV). Parameters marked as * are defined by end customer as in Table 1.

Table 1

| Value of first capacitor, C1 | 4773.1 pF (Pico Farad) |
| --- | --- |
| Value of second capacitor, C2 | 62058.1 pF |

(continued)

| C1+ C2 | 66831.2 pF |
|---|---|
| *Rated Voltage, $U_r$ | $220/\sqrt{3}$ Kilo volts (KV) |
| *Equivalent Capacitance, $C_{equivalent}$ | 4432 pF ; expected 4400pF (+10% to -5%) |
| Voltage at primary section of intermediate transformer, V1 Ur*C1/ (C1+C2) | 9.07 Kilo volts (KV) |
| *Voltage at secondary section, V2 | 63.5 Volts |
| Voltage ratio (V2:V1)of intermediate transformer | 142.8 |
| Number of turns on secondary windings, N2 @ 0.9 Tesla | 50 turns |
| Number of turns on primary windings, N1 | 7157 turns |
| Turn Ratio (N2:N1) | 143.1 |
| Xc=1/[2*3.147*$F_r$*(C1+C2)] = Xl ohm | 47547.4 ohm |
| Inductance L = Xl / (2*3.147*$F_r$) | 151Henry |
| $A_g$, area of gap (same as cross section of area Ac) | (40.5+40.5)*100 *0.95 = 7695 square milli meter and 0.007965 square meter [i.e. Core limb area (40.5+40.5) * 100 (width of the core 218B) * stacking factor of 0.95 (i.e. 5% non- conductor area on the core 218B)] |
| Vacuum permeability, $\mu_o$ (universal constant) | 0.0000013 |
| $l_g$ Gap can be calculated as L= $\mu_o$*N*N*$A_g$/$l_g$ | 0.003284 meter |
| $l_g$, length of gap | 3.284 milli meter (mm) in total for two limbs |
| $l_g$ Gap can be calculated on single limb | 1.64 milli meter (mm) for each limb |

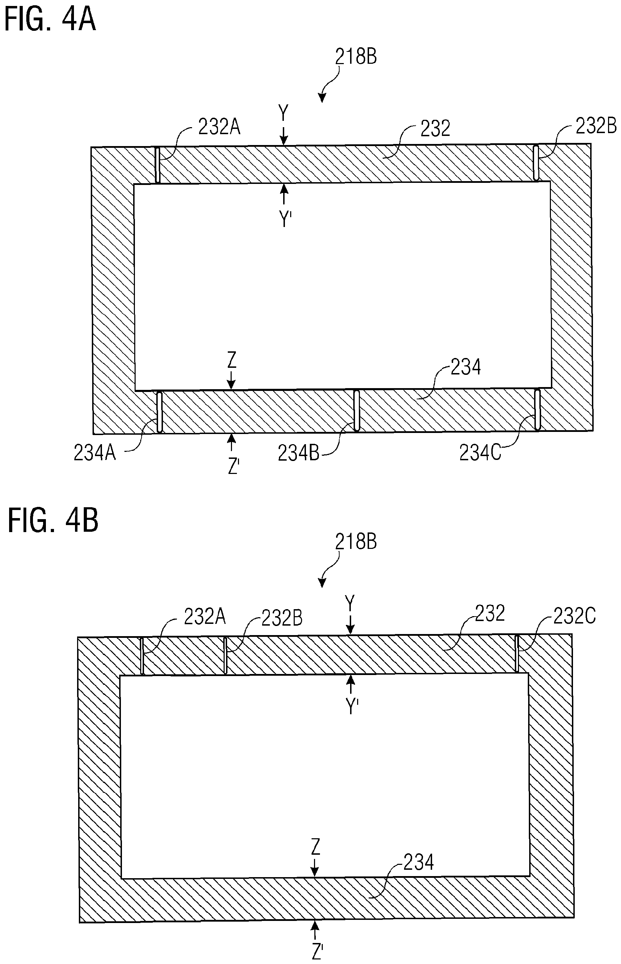

In an embodiment, the one or more gaps 232A, 234A produce the inductance in a range of 50-170 Henry (H) in the primary section 218A(1) of the intermediate transformer 218 based on end application and on the equivalent capacitance requirement (i.e. (C1*C2)/(C1+C2) as explained above). In one exemplary embodiment, each of the gaps 232A, 234A on both the first limp 232 and the second limp 234 may range between 10 microns to 5 millimeter (mm) in length. In an embodiment, a gap size of 1.65 milli meter (mm) may be configured on both the limps 232, 234. The gaps 232A, 234A may be formed on one or more location of the core 218B which is explained in FIGS 4A-4C.

In an embodiment, non-magnetic steel or an insulating clamp & winding former may be placed separately on the core 218B to fix the intermediate transformer 218 inside the EMU tank 214. Such clamp ensures the gap length introduced in the core 218B. After ensuring the inductance in the circuit 300, the clamp is tightened on the core 218B by nut bolt mechanism as known in the art.

The intermediate transformer 218 plays a dual rule of, including but not limited to, achieving transformation ratio from the primary side 218A(1) of the intermediate transformer 218 to the secondary side 218A(2) of the intermediate transformer 218 and eliminating phase error from the primary side 218A(1) of the intermediate transformer 218 by producing the inductance in the primary side 218A(1) of the intermediate transformer 218 using gaps 232A, 234A without having using any dedicated and separate section of physical compensating inductors. The capacitor voltage transformer 300 is configured such that to compensate the inductance requirement in the circuit 300 and hence avoiding the phase error.

FIG 3B is a circuit diagram depicting magnetic coupling between a tuning choke coil and a core of an intermediate transformer, in accordance with an embodiment of the present invention. As depicted in FIG 3B, the primary section 218A(1) of the intermediate transformer 218 and the secondary section 218A(2) of the intermediate transformer 218 is separated by the core 218B. The secondary section 218A(2) of the intermediate transformer 218 comprises the tuning choke coil 226, the first set of fuses 236, and the second set of fuses 238. Furthermore, the secondary section 218A(2) of the intermediate transformer 218 includes a plurality of windings on the at least one limp 232, 234 of the core 218B, wherein the plurality of windings include a first winding magnetically coupled to the tuning choke coil 226, a second winding connected to the filter 224, and a third winding coupled to the tuning choke coil 226 and terminates in the first set of fuses 236. Further, a fourth winding is coupled to the tuning choke coil 226 and terminates in the second set of fuses 238. On one end, the tuning choke coil 226 is magnetically coupled with an end terminal of the first set of fuses 236 and at other end, the tuning choke coil 226 is magnetically coupled with a start terminal of the second set of fuses 236. Additionally, if required, an inductance coil 240A, 240B of 63.5-110 volts in a range of 3-8 milli-Henry (mH) may be introduced in secondary windings of the secondary section 218A(2) of the intermediate transformer 218 to achieve a stable behavior of the CVT 300. Whenever, there is change in number of turns of the secondary windings, flux density of the intermediate transformer 218 changes and subsequently the secondary voltage at the secondary section will change as per the required value desired by the customer by tuning.

FIGS 4A-4D depict one or more gaps on limb/s of an exemplary core of an intermediate transformer 218, in accordance with an embodiment of the present invention. Referring to FIG 4A, in one embodiment, the core 218B has two limbs, namely a first limb 232 and a second limb 234. As depicted in FIG 4A, the first limb 232 includes a first gap 232A and a second gap 232B formed at two different locations on the first limb 232. Further, the second limb 234 includes a first gap 234A, a second gap 234B and a third gap 234C formed at three different locations on the second limb 234. Moreover, each of the first gap 232A and the second gap 232B formed on the first limb 232 are longitudinal gaps ranges/starts from a first end Y of the first limb 232 and ends at a second end Y' of the first limb 232. In the same way, each of the first gap 234A, the second gap 234B and the third gap 234C formed on the second limb 234 are longitudinal gaps ranging/starting from a first end Z of the first limb 234 and ending at a second end Z' of the second limb 234.

Referring to FIG 4B, in one embodiment, the first limb 232 includes three gaps, namely, a first gap 232A, a second gap 232B and a third gap 232C formed at three different locations on the first limb 232 starting from the first end Y to the second end Y' of the first limb 232. Herein, the second limb 234 does not include any gaps as shown.

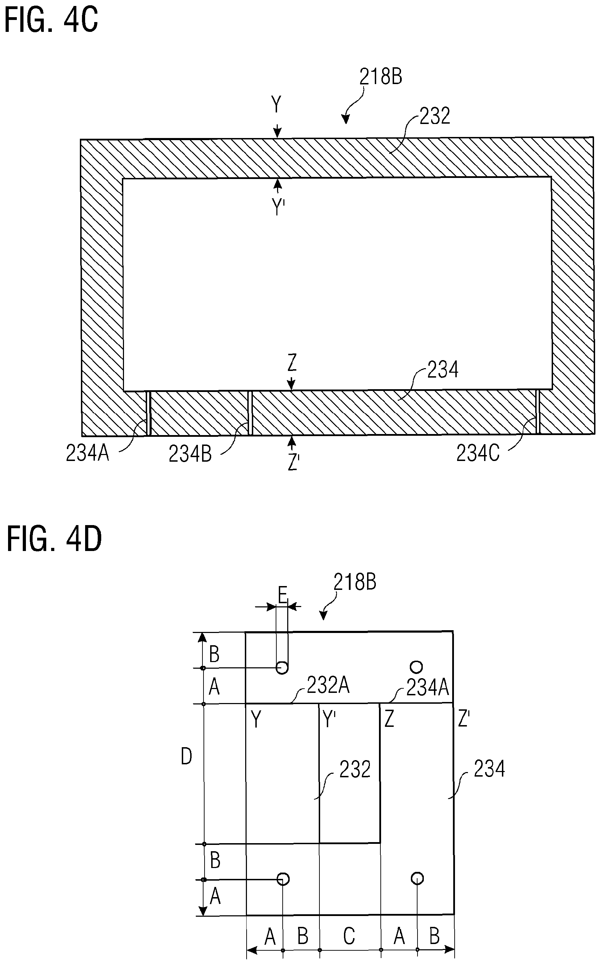

Referring to FIG 4C, in one embodiment, the first limb 232 does not include any gap. Further, the second limb 234 includes three gaps i.e. a first gap 234A, a second gap 234B and a third gap 234C formed at three different locations on the second limb 234 as shown. It is to be noted herein that the number of gaps on each limb 232, 234 may vary depending on the requirement of compensating inductance in the CVT 300 as discussed above. In an embodiment, the one or more gaps 232A, 234A on the at least one limb 232, 234 are equal in length. In another embodiment, the one or more gaps 232A, 234A on the at least one limb 232, 234 are different in length.

Figure 4D depicts the first limb 232 including the first gap 232A on the first limb 232 and the second limb 234 including the first gap 234A on the second limb 234. The first gap 232A on the first limb 232 ranges from the first end Y to the second end Y' of the first limb 232 and the second gap 234A on the second limb 234 ranges from the first end Z to the second end Z' of the second limb 234. As depicted in 4D, ((2*A)+(2*B)+C) together form a total length of the core 218B. By way of an example, the value of A is 40.5 millimeter (mm), the value of B is 40.5 mm and the value of C is 68.0 mm. Similarly, ((2*A)+(2*B)+D) together form a total height of the of the core 218B. By way of an example, the value of A is 40.5 mm, the value of B is 40.5 mm and the value of D is 156.0 mm. The value of E which is a hole on the core 218B is 13*4 mm.

FIG 5 depicts a graph of voltage transformation ratio achieved for intermediate transformer 218 in accordance with the present invention. Graph 500 in FIG 5 is plotted for medium voltage (MV) V1 applied on primary section 218A(1) (i.e. HV side) of the intermediate transformer 218 and voltage V2 measured on secondary section 218A(2) of the intermediate transformer 218. Table 2 below shows experimental values of voltage V1 applied on the primary section 218A(1) of the intermediate transformer 218 and experimental values of voltage V2 measured on the secondary section 218A(2) of the intermediate transformer 218. Table 3 below shows theoretical values of voltage V1 applied on the primary section 218A(1) of the intermediate transformer 218 and theoretical values of voltage V2 on the secondary section 218A(2) of the intermediate transformer 218. In the graph 500, a comparison of an ideal graph (using the theoretical values in Table 3) with a practical extrapolation (using experimentation values in Table 2) is shown to depict that the voltage transformation ratio (i.e. k = V1 divided by V2) in the secondary section 218A(2) of the intermediate transformer 218 is achieved.

Table 2 - Experimentation values

| MV Voltage applied on HV Side (V1) | Measured Secondary voltage (V2) |
|---|---|
| 140 | 1.40 |
| 330 | 2.80 |
| 570 | 4.50 |
| 800 | 6.20 |
| 22020 | 7.70 |
| 2220 | 9.10 |

(continued)

| MV Voltage applied on HV Side (V1) | Measured Secondary voltage (V2) |
|---|---|
| 1400 | 10.40 |

Table 3 - Theoretical values

| Applied MV Voltage on HV Side (V1) | Expected Secondary voltage (V2) |
|---|---|
| 0000 | 0.00 |
| 0907 | 6.35 |
| 1814 | 12.70 |
| 2721 | 19.05 |
| 3628 | 25.40 |
| 4535 | 31.75 |
| 5442 | 38.10 |
| 6349 | 44.45 |
| 7256 | 50.80 |
| 8163 | 57.15 |
| 9070 | 63.50 |

FIG 6 depicts a graph of achieving compensating inductance in primary section 218A(1) of intermediate transformer 218 in accordance with the present invention. Graph 600 in FIG 6 is plotted for MV voltage V1 applied on the primary section 218A(1) (i.e. HV side) of the intermediate transformer 218 and current I measured on the primary section 218A(1) of the intermediate transformer 218. Table 4 below shows experimental values of voltage V1 applied on the primary section 218A(1) of the intermediate transformer 218 and experimental values of current I measured on the primary section 218A(1) of the intermediate transformer 218. In the graph 600, a comparison of an ideal graph (using theoretical values) with a practical extrapolation (using experimentation values in Table 3) is shown to depict that the compensating inductance of 156 Henry (H) in the primary section 218A(1) of the intermediate transformer 218 is achieved for 245 KV CVT as explained above. Herein, the current on HV side can be measured using formula of V1N1 = V2N2 = K (transformation ratio) and V2 = 4.44*B (flux density) *Ac(Core Area)*N2*Fr and XI =V/I (Gap adjusting current, I). It is to be noted that the values of voltages and current mentioned in Tables 2, 3, 4 are practically measured or theoretically calculated at dry stage without using oil in the EMU tank 216. It is to be further noted that the experimentation done after the dry stage using the oil in the EMU tank 216 yields same values as to the practically measured or theoretically calculated at the dry stage which further validates the dual functionality of the intermediate transformer 218.

Table 4

| Applied MV Voltage on HV side (V1) | Measured Current on HV side (I) |
|---|---|
| 140 | 3.6 |
| 330 | 7.2 |
| 570 | 11.5 |
| 800 | 15.8 |
| 2020 | 19.5 |
| 2220 | 23.1 |
| 1400 | 26.3 |

While the present disclosure has been described in detail with reference to certain embodiments, it should be appreciated that the present disclosure is not limited to those embodiments. In view of the present disclosure, many modifications and variations would be present themselves, to those skilled in the art without departing from the scope of the various embodiments of the present disclosure, as described herein. The scope of the present disclosure is, therefore, indicated by the following claims rather than by the foregoing description. All changes, modifications, and variations coming within the meaning and range of equivalency of the claims are to be considered within their scope.

**Claims**

1. A capacitive voltage transformer (CVT) (300) comprising:

   an intermediate transformer (218);
   wherein the intermediate transformer (218) comprises a core (218B) having at least one limb (232, 234), **characterized in that** the at least one limb (232, 234) is configured with one or more gaps (232A, 232B, 234A, 234B, 234C) for producing a compensating inductance in a primary section (218A(1)) of the intermediate transformer (218) for eliminating phase error in the CVT (300).

2. The CVT (300) according to claim 1, wherein the one or more gaps (232A, 234A) on the at least one limb (232, 234) are longitudinal starting from a first end (to a second end of the at least one limb (232, 234).

3. The CVT (300) according to claim 1, wherein each of the one or more gaps (232A, 234A) on the at least one limb (232, 234) range between 10 microns to 5 millimeter (mm) in length.

4. The CVT (300) according to claim 1, wherein the one or more gaps (232A, 234A) on the at least one limb (232, 234) are equal in length.

5. The CVT (300) according to claim 1, wherein the one or more gaps (232A, 234A) on the at least one limb (232, 234) are different in length.

6. The CVT (300) according to claim 1, wherein the one or more gaps (232A, 234A) produce the inductance in a range of 50-170 Henry (H) in the primary section (218A(1)) of the intermediate transformer (218) based on equivalent capacitance requirement.

7. The CVT (300) according to claim 1, wherein the intermediate transformer (218) comprises a secondary section (218A(2)) having a tuning choke coil (226).

8. The CVT (300) according to claim 7, wherein the tuning choke coil (226) is magnetically coupled to the core (218B) of the intermediate transformer (218) for tuning transformation ratio error.

9. The CVT (300) according to claim 7, wherein an inductance coil in a range of 3-8 milli-Henry (mH) is introduced in secondary windings in the secondary section (218A(2)) of the intermediate transformer (218) to achieve a stable behavior of the CVT (300).

10. The CVT (300) according to claim 1, wherein the one or more gaps (232A, 232B, 234A, 234B, 234C) are filled using at least one of a mylar film, a polypropylene film and a press board.

11. An intermediate transformer (218) comprising:

    a core (218B) having at least one limb (232, 234), **characterized in that**
    the at least one limb (232, 234) is configured with one or more gaps (232A, 232B, 234A, 234B, 234C) for producing compensating inductance in a primary section (218A(1)) of the intermediate transformer (218) for eliminating phase error in a circuit (300).

# FIG. 1
## (PRIOR ART)

FIG. 2

FIG. 3A

FIG. 3B

## FIG. 4A

## FIG. 4B

## FIG. 4C

## FIG. 4D

## FIG. 5

## FIG. 6

**Europäisches Patentamt**
**European Patent Office**
**Office européen des brevets**

# EUROPEAN SEARCH REPORT

Application Number

EP 20 21 3448

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 201 229 831 Y (CHINA XINDIAN ELECTRIC CO LTD [CN]) 29 April 2009 (2009-04-29) | 1-6,10,11 | INV. H01F38/26 |
| Y | * figures 3,1 * * corresponding description * | 7-9 | H01F3/14 H01F27/42 G01R15/06 |
| X | DE 11 44 841 B (SIEMENS AG) 7 March 1963 (1963-03-07) | 1-6,10,11 | |
| Y | * figures 2,1 * * corresponding description * | 7-9 | |
| X | CN 204 287 284 U (CHINA XD ELECTRIC CO LTD) 22 April 2015 (2015-04-22) | 1-6,10,11 | |
| Y | * figures 3,1 * * corresponding description * | 7-9 | |
| X | DE 11 54 570 B (FARBENFAB BAYER AG) 19 September 1963 (1963-09-19) | 1-6,10,11 | |
| Y | * figures 3,4 * * corresponding description * | 7-9 | |
| Y | US 3 943 435 A (DEJARNETTE MALCOLM B) 9 March 1976 (1976-03-09) * figures 2,4 * * corresponding description * | 7-9 | TECHNICAL FIELDS SEARCHED (IPC) H01F G01R |
| E | WO 2021/023472 A1 (SIEMENS ENERGY GLOBAL GMBH & CO KG [DE]) 11 February 2021 (2021-02-11) * figure 11 * * corresponding description * | 11 | |

The present search report has been drawn up for all claims

| Place of search | Date of completion of the search | Examiner |
|---|---|---|
| Munich | 18 May 2021 | Weisser, Wolfgang |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 21 3448

This annex lists the patent family members relating to the patent documents cited in the above-mentioned European search report.
The members are as contained in the European Patent Office EDP file on
The European Patent Office is in no way liable for these particulars which are merely given for the purpose of information.

18-05-2021

| Patent document cited in search report | | Publication date | Patent family member(s) | | Publication date |
|---|---|---|---|---|---|
| CN 201229831 | Y | 29-04-2009 | NONE | | |
| DE 1144841 | B | 07-03-1963 | CH | 400356 A | 15-10-1965 |
| | | | DE | 1144841 B | 07-03-1963 |
| | | | SE | 301520 B | 10-06-1968 |
| CN 204287284 | U | 22-04-2015 | NONE | | |
| DE 1154570 | B | 19-09-1963 | NONE | | |
| US 3943435 | A | 09-03-1976 | NONE | | |
| WO 2021023472 | A1 | 11-02-2021 | DE 102019211948 A1 | | 11-02-2021 |
| | | | WO | 2021023472 A1 | 11-02-2021 |

EPO FORM P0459

For more details about this annex : see Official Journal of the European Patent Office, No. 12/82